# EUROPÄISCHE PATENTSCHRIFT

(11) **EP 1 777 810 B1**
(45) Veröffentlichungstag und Bekanntmachung des Hinweises auf die Patenterteilung: **13.12.2017**
(21) Anmeldenummer: 06021380.8
(22) Anmeldetag: 12.10.2006
(51) Int. Cl.: H01Q 3/26, H01T 9/00, H03B 11/02, F41H 13/00

(54) **Mikrowellengenerator**
Microwave generator
Générateur de micro-ondes

(30) Priorität: 17.10.2005 DE 102005049538
(43) Veröffentlichungstag der Anmeldung: 25.04.2007
(73) Patentinhaber: Diehl Defence GmbH & Co. KG, 88662 ÜBERLINGEN (DE)
(72) Erfinder: Ganghofer, Andreas, 90552 Röthenbach (DE); Staines, Geoffrey, Dr., San Diego 92111 (US); Urban, Jürgen, Dr., 91056 Erlangen (DE)
(74) Vertreter: Diehl Patentabteilung

(56) Entgegenhaltungen:
- DE-B3- 10 313 286
- US-A- 4 329 686
- US-B1- 6 337 660
- US-B1- 6 768 458

## Beschreibung

Die Erfindung betrifft ein Antennen-Array gemäß dem Oberbegriff des Patentanspruchs 1. Ein solches Antennen-Array ist aus der DE 103 13 286 B3 bekannt.

Das Array soll ein hochenergetisches Mikrowellenfeld abstrahlen, sobald die beispielsweise aus einem Marx-Generator auf Hochspannung aufgeladenen Resonatoren über Funkenstrecken entladen werden, um ein Ziel, insbesondere dessen elektronischen Schaltungen der Kommunikations- und der Datentechnik, störend oder zerstörend zu beeinflussen. Bei einem solchen Array überlagern sich die abgestrahlten Felder mit dem Effekt einer stärkeren Wirkung bzw. einer größeren Wirkreichweite in der Überlagerungsrichtung allerdings nur, wenn die Funkenstrecken zeitsynchron zünden. Zwar sind die unvermeidlichen stochastischen Ansprechverhalten von Funkenstrecken für die Wirkung solcher Überlagerungen vernachlässigbar - nicht aber systematische Effekte wie die Laufzeiteinflüsse von unterschiedlichen Leitungslängen und die Verlängerungen von Funkenstrecken infolge unterschiedlichen Elektrodenabbrandes im Betrieb. Daraus resultiert, dass die Antennen derartiger Arrays trotz ursprünglichen Abgleichs auf synchrones Ansprechen der Funkenstrecken in der Praxis bald nicht mehr synchron, sondern zu zunehmend gegeneinander versetzten Zeitpunkten aus den Kondensatorentladungen bestromt werden und deshalb dann nicht mehr zu phasengleichen Feldüberlagerungen führen. Mit für die Belange der Praxis verfügbaren messtechnischen Mitteln ist jedoch nur feststellbar, dass die Antennen des Array aufgrund des jeweiligen Funkenstrecken-Überschlags angeregt werden. Wenn dann aber in gewissem Abstand vor diesem Antennen-Array keine, insbesondere keine überhöhte, Strahlungsdichte feststellbar ist, dann kann das nur daran liegen, dass die Funkenstrecken unsynchronisiert gezündet haben.

In Erkenntnis dieser Gegebenheiten liegt der vorliegendern Erfindung die technische Problemstellung zugrunde, die Wirkung der von derartigen Antennen-Arrays abgestrahlten Mikrowellenenergie im Ziel zu verbessern.

Die erfindungsgemäße Lösung dieser Aufgabe ergibt sich aus der Merkmals-Kombination des Hauptanspruches. Danach ist unter anderen vorgesehen, das Zündansprechverhalten der einzelnen Resonator-Funkenstrecken dieses Antennen-Array individuell zu verändern, bis sich ein zeitgleiches Ansprechverhalten der Funkenstrecken einstellt. Gleiches Ansprechverhalten bedeutet im Zusammenhang mit vorliegender Erfindung, dass bei allen parallel betriebenen Resonatoren die Kondensator-Entladeströme zur Speisung ihrer Antennen zeitgleich einsetzen. Das hat dann zur Folge, dass der Strom vor seinem oszillierenden Abklingen in allen Antennen gleichzeitig mit steiler Anstiegsflanke einsetzt. Dann tragen, aufgrund dieser gewissermaßen konstruktiven Überlagerung, in wünschenswerter Weise alle Antennen phasengleich, nämlich zeitlich synchronisiert zur Abstrahlung von Mikrowellenenergie bei, was im Fernfeld zu einer messbaren Intensitätsüberlagerung, also zu größerer Wirkreichweite führt.

Für eine gezielte Veränderung des Ansprechverhaltens der jeweiligen Funkenstrecke können ihre Elektroden relativ zueinander mechanisch einstellbar sein, beispielsweise mittels Schraubbolzen, die mehr oder weniger tief durchgreifend in den Boden einer topfförmigen Außenelektrode in Richtung auf den Scheitel des konvexen Bodens einer flaschenförmigen Innenelektrode des Resonators einschraubbar sind. Dieses Ein- und Ausschrauben erfolgt zweckmäßigerweise mittels eines Stellmotors, so dass kein manuelles Hantieren im Hochspannungsbereich der Resonatoren erforderlich wird. Auch andere Stellsysteme sind hier vorteilhaft einsetzbar, etwa Piezoaktuatoren in Reihe mit den Elektroden. Bei einer besonders preiswert realisierbaren pneumatischen Einstellung wird mittels variierbaren Fluiddruckes ein Kolben mit der verstellbaren Elektrode gegen die Haltekraft einer Rückstellfeder verschoben.

Zur gezielten Beeinflussung des Ansprechverhaltens der Funkenstrecke des jeweiligen Resonators, im Interesse einer zeitgleichen Überlagerung des Einsetzens der impulsförmig abgestrahlten Energiebeiträge, kann zusätzlich zur Abstandsvariation zwischen den Funkenstrecken-Elektroden oder statt dessen auch vorgesehen sein, den Fluiddruck des dielektrischen Mediums im Raum zwischen den beiden Elektroden zu verändern, indem etwa über eine Pumpe bzw. durch ein Entspannungsventil im jeweiligen Resonator ein höherer Druck aufgebaut bzw. Druck abgelassen wird.

Eine Verringerung des Elektrodenabstandes bzw. eine Verringerung des Dielektrikums-Druckes zwischen den Elektroden führt zu einem früheren Überschlag der Funkenstrecke im Zuge des Aufladens der Resonatorkapazität auf die hohe Ausgangsspannung eines Marx-Generators und somit zu einem früheren Einsetzen der Bestromung der Antenne.

Als Problem verbleibt allerdings noch die messtechnische Feststellung, welche der Funkenstrecken eines Array zu früh und welche zu spät in Bezug auf die wünschenswerte, zeitlich exakte Überlagerung des Einsetzens der Abstrahlung von Mikrowellenenergie zünden. Das ist mit den in der Hochfrequenztechnik üblichen Feldmessgeräten nicht präzise feststellbar, weil die auf die Leistung des abgestrahlten Spektrums ansprechen. Mit einer Feldsonde kann deshalb nicht das Verhalten einer einzelnen Antenne aus dem Array ausgemessenen werden, das Ausmessen überlagerter Felder mit der Sonde führt zu zeitlichem Verschleifen der Pulsformen der einzelnen Antennenbeiträge. Gemäß einer Weiterbildung vorliegender Zusatzerfindung ist deshalb vorgesehen, das Auftreten des Lichtblitzes beim Durchzünden der jeweiligen Funkenstrecke optoelektronisch zu erfassen und die dabei auftretenden zeitlichen Abstände auszuwerten. Dazu kann ein Detektor nahe der Funkenstrecke zwischen Innen- und Außenelektrode im Resonator eingebaut sein. Zweckmäßiger ist es jedoch, hier eine optische Faser enden zu lassen, an die erst abseits der Funkenstrecke und damit in elektromagnetisch weniger störkritischem Umfeld auf den optoelektronischen Detektor geführt ist. Dieser liefert eine mit dem Einsetzen des Durchzündblitzes der Funkenstrecke steil ansteigende Ausgangsspannung. Die von den einzelnen Funkenstrecken kommenden Spannungsverläufe können in einem mehrkanaligen Oszillographen parallel dargestellt werden, um festzustellen, in welcher Reihenfolge und mit welchem zeitlichen Versatz die einzelnen Funkenstrecken des Antennen-Array ansprechen. Es können dann, wie vorstehend angesprochen, die Fluiddrücke bzw. die Elektrodenabstände in den einzelnen Resonatoren dahingehend verändert werden, dass die Funkenstrecken-Überschläge möglichst zeitgleich einsetzen und damit zu einander im Fernfeld phasenrichtig überlagerten Abstrahlungen von den Antennen des Array führen.

Eine derartige oszillographische Darstellung ist allerdings im wesentlichen nur im Laborbetrieb sinnvoll einsetzbar. Für die Belange der Praxis wäre es wünschenswert, je nach den momentanen Umgebungseinflüssen in kürzeren Abständen oder sogar quasi-kontinuierlich den Zeitpunkt des Einsetzens des Entladefunkens zwischen den Elektroden des kapazitiven Resonators überwachen und nachjustieren zu können. Dann ist es z.B. möglich, etwa im Bereich der Frontscheinwerfer eines Sicherungsfahrzeugs je ein solches Antennen-Array anzuordnen und unter derart spitzem gegenseitigen Winkel voraus auszurichten, dass die stets optimierten Antennenabstrahlungen vor jedem der Arrays an einem Ort voraus zur überlagerten Einwirkung gebracht werden, nämlich durch elektromagnetische Übersteuerung infolge der überlagerten Feldstärken der beiden intensivierten Richtstrahlen etwa zum Stören oder gar Zerstören der Zündelektronik einer Mine, einer Sprengfalle oder der Eingangsschaltung einer Kommunikationseinrichtung führen.

Gemäß vorliegender erfindung wird nun während des Betriebes der Antennen-Arrays darin jeweils die Anordnung der optoelektronischen Detektoren zur Überwachung des Einsetzens der Zündfunken auf eine mitgeführte Zeitmesseinrichtung geschaltet, mittels derer der gegenseitige zeitliche Abstand des Einsetzens der Zündfunken im jeweiligen Array mehrkanalig parallel gemessen wird. Diese Zeitmesswerte werden in einer Steuerschaltung umgesetzt in Stellgrößen für eine insbesondere elektromotorische Variation des Zündelektroden-Abstandes bzw. des Fluiddruckes im jeweiligen Resonator eines Arrays, bis das Einsetzen der Entladung auf die jeweilige Antenne zeitlich koordiniert ist. Diese Messungen und die daraus resultierenden Funkenstrecken-Justagen können also nun während des Einsatzes eines Arrays zur hochenergetischen Mikrowellenabstrahlung vorgenommen werden, weshalb eine iterative energetische Optimierung schon im Zuge der Annäherung an einen sicherheitskritischen Bereich erfolgen kann.

Bezüglich zusätzlich erfinderischer Alternativen und Weiterbildungen sowie deren Vorteilen wird außer auf die weiteren Ansprüche auch auf nachstehende Beschreibung des in der Zeichnung unter Beschränkung auf das Wesentliche stark abstrahiert skizzierten bevorzugten Realisierungsbeispiels zur erfindungsgemäßen Lösung verwiesen. In der Zeichnung zeigt:

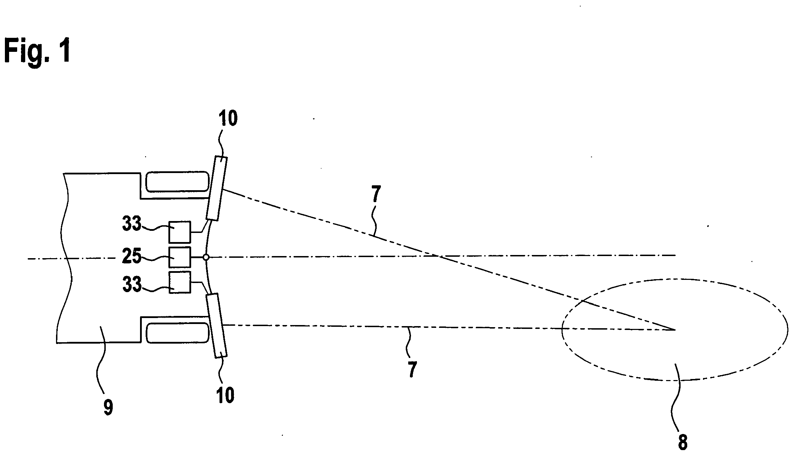

- Fig. 1: in Draufsicht ein Überwachungsfahrzeug mit zwei vor seiner Kühlerhaube montierten Mikrowellen-Arrays, deren Abstrahlungen auf einen vergleichsweise eng begrenzten Bereich in größerem Abstand seitlich vor dem Fahrzeug fokussiert sind, und

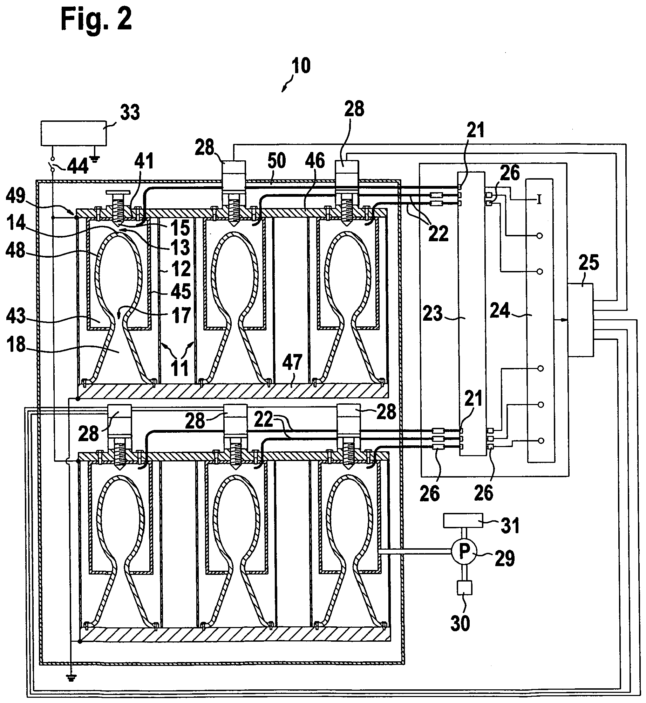

- Fig. 2: in Vorderansicht eines der Arrays gemäß Fig. 1, ausgestattet mit optoelektronischer Einkopplung einer Messeinrichtung für den zeitlichen Versatz des Ansprechens seiner Funkenstrecken und mit einer Steuereinrichtung zur Veränderung des Ansprechverhaltens einzelner Funkenstrecken unter Berücksichtigung zweier verschiedener Möglichkeiten zur Beeinflussung des Ansprechverhaltens.

Um hochenergetische Mikrowellenstrahlung 7 auf einen Wirkbereich 8 vor beispielsweise einer land-, luft- oder seeverbringbaren Überwachungs-Plattform, nachstehend einfach als Fahrzeug 9 bezeichnet, zu fokussieren, sind in diesem bevorzugten Beispielsfalle zwei Arrays 10 am Fahrzeug 9 montiert, etwa an beiden Seiten vor der Kühlerhaube. Jedes der beiden Arrays 10 besteht gemäß Fig. 2 aus mehreren Mikrowellen-Generatoren 11. Die weisen koaxial in einem hohlzylindrischen Gehäuse 12 aus elektrisch isolierendem Material eine koaxiale Funkenstrecke 13 zwischen einer kugelkappenförmigen Elektrode 14 und einer dagegen spitzen Elektrode 15 auf. Diese Funkenstrecke 13 ist Lichtbogen-Entladestrecke für die auf Durchbruchspannung aufgeladene Kapazität eines koaxialen Resonators, dessen Außenelektrode 45 mit der spitzen Elektrode 15 verbunden ist, während die konvexe Lichtbogen-Elektrode 14 Teil eines flaschenförmig hohlen Innenleiters 48 ist. An dessen flaschenhalsförmige, der Funkenstrecke 13 gegenüber aus der Außenelektrode 45 heraustretende Verjüngung 17 schließt sich innerhalb des Gehäuses 12 die kleine Basis einer spitzwinklig hohlkegelstumpfförmigen Antenne 18 an. Die wirkt infolge dieser Trichterform als Impedanzwandler für das Abstrahlen eines Hochfrequenzgemisches, wenn die auf Hochspannung aufgeladene Kapazität 43 des Mikrowellen-Resonators über die Funkenstrecke 13 zur Entladung in die Antenne 18 kurzgeschlossen wird.

Die den Boden 41 des Resonators durchdringende spitze Elektrode 15 ist wie skizziert als Schraubbolzen mit Feingewinde ausgelegt, mittels dessen sich der lichte Abstand der Funkenstrecke 13 zur entsprechenden Beeinflussung der Durchschlagsfeldstärke feinfühlig verändern lässt. Die Funkenstrecke 13 spricht an, wenn die Kapazität 43 über eine Schaltstrecke 44 aus einer Hochspannungsquelle 33 hinreichend aufgeladen ist, bei der es sich bevorzugt um eine Kondensatorbatterie mit Umschaltmaßnahmen nach Art der Marx'schen Stossspannungsschaltung handelt. Die mit dem Entladefunken über die Strecke 13 einsetzende Entladung der Kapazität 43 führt zu einem steil einsetzenden und dann stark oszillierend abklingenden Stromfluss in der Antenne 18, der als entsprechend steil einsetzendes hochenergetisches Mikrowellengemisch abgestrahlt wird.

Gemäß Fig. 2 sind mehrere solcher Mikrowellen-Generatoren 11 unter Parallelschaltung ihrer Kapazitäten 43 zeilen- und spaltenförmig vor einer elektrisch leitenden Abschirmfläche 50 mittels elektrisch leitender Konsolen 46, 47 mechanisch gehaltert und elektrisch zum Strahler-Array 10 parallel geschaltet. Wenn alle Funkenstrecken 13 eines solchen Array 10 gleichzeitig ansprechen, strahlen die Antennen 18 im wesentlichen phasengleich einsetzende Spektren ab, die sich dann in Richtung quer zur Ebene der Platte 50 phasenrichtig überlagern und deshalb zu einer Erhöhung der Wirkreichweite eines energiereichen Strahles 7 im Mikrowellenspektrum führen. Der Abstand der Antennen 18 von der elektrisch reflektierenden Abschirmfläche 50 beeinflusst den wirksamen spektralen Schwerpunkt im abgestrahlten Mikrowellenspektrum aus der Überlagerung der Beiträge von den einzelnen Antennen 18. Ein energetisch wirksamer Überlagerungseffekt verlangt allerdings wie schon ausgeführt ein zeitgleiches Einsetzen der abgestrahlten Impulse und somit ein gleichzeitiges Einsetzen der Entladelichtbögen über die Funkenstrecken 13. Das ist jedoch schon aufgrund der atmosphärischen und konstruktiven Gegebenheiten in der Umgebung der Funkenstrecke 13 nicht ohne weiteres gewährleistet; aber auch deshalb nicht, weil die unterschiedlich langen Ladewege von der Hochspannungs-Einspeisung 49 über die Konsolen 46/47 die Wirkungen unterschiedlicher Induktivitäten haben und damit infolge unterschiedlicher Ladezeitkonstanten zu Ladeverzögerungen in den von der Einspeisung 49 entfernter gelegenen Resonatoren führen. Zwar wird man sich gerade aus diesem Grunde bemühen, alle Leitungen gleich lang zu halten, um zu große systematische Zeitfehler zu vermeiden; aber hinsichtlich der unvermeidlichen Fertigungstoleranzen, thermischen Effekte und Abnutzungserscheinungen erfahren die Funkenstrecken ihre Feinabstimmung aufeinander über die optoelektronische Funkenerfassung.

Um das Einsetzen der Entladung der jeweiligen Resonator-Kapazität 43 über die Funkenstrecke 13 in die Antenne 18 messtechnisch zu erfassen, ist jeder Funkenstrecke 13 im Array 10 ein optoelektronischer Detektor 21 zugeordnet. Der ist gemäß dem skizzierten bevorzugten Realisierungsbeispiel über einen Lichtleiter 22 an die unmittelbare Nähe der Funkenstrecke 13 angeschlossen. In einer Vorverarbeitungsschaltung 23 werden die Ausgangsspannungen der Detektoren 21 verstärkt. Sodann wird jeweils aus der steigenden Impulsflanke des verstärkten Signals ein Triggersignal gewonnen; vorzugsweise über Anwendung eines Constant Fraction Trigger (CFT) auf die ansteigende Impulsflanke, wie für einen anderen Anwendungsfall in der DE 1 00 26 534 A1 beispielhaft beschrieben. Mit diesen den einzelnen Funkenstrecken zugeordneten Triggersignalen werden die Kanäle mehrerer einander parallel geschalteter zweikanaliger Zeitzähler oder eines vierkanaligen Zeitzählers 24 angesteuert. Der liefert an eine Steuerschaltung 25 für jeden Kanal des Zeitzählers 24 und somit für jede Funkenstrecke 13 des Array 20 einen Digitalwert über den relativen Zeitpunkt des Ansprechens dieser Funkenstrecke 13 in Bezug auf die weiteren Funkenstrecken 13 dieses Array 10.

Damit der Zeitzähler 24 für diese Messung definiert startet, ist für jeden Messkanal eine Verzögerung 26 vorgesehen. Wenn die vor der Vorverarbeitungsschaltung 23 gelegen ist, wird sie zweckmäßiger Weise über die Länge des Lichtleiters 22 realisiert; dagegen wird eine hinter der Vorverarbeitungsschaltung 23 wirksame Verzögerung 26 zweckmäßiger Weise schaltungstechnisch realisiert. Diese Verzögerungen 26 sind nur bei einer einzigen der aus einem Array 10 von einem Zähler 24 erfassten Funkenstrecken 13 nicht realisiert. Der dieser Antenne 18 bzw. ihrer Funkenstrecke 13 zugeordnete Messkanal kann als Master bezeichnet werden, weil auf ihn dann die Zündzeitpunkte aller anderen Kanäle angepasst werden. Denn aufgrund der beim Master fehlenden Verzögerung wird die detektierte Lichterscheinung vom Entladefunken dieser einen Funkenstrecke 13 auf jeden Fall früher als all die anderen (verzögerten) zum Zeitzähler 24 gemeldet, womit der Zeitzähler 24 zuverlässig gestartet wird, ehe (nun in Bezug auf diesen Referenzzeitpunkt) die Stoppsignale von anderen Funkenstrecken 13 zugeordneten Kanälen eintreffen. Das Schaltverhalten der einzelnen Funkenstrecken 13 wird dann derart beeinflusst, dass die einzelnen Zeitspannen in Bezug auf den Startmoment des Zeitzählers 24 möglichst gegen Null gehen, weil dann die steilen Anfangsflanken der Mikrowellenabstrahlung aus den einzelnen Antennen 18 optimal da zeitgleich einsetzen.

Um ein bezüglich des Masters, also des Startmomentes des Zeitzählers 24 zu spätes Einsetzen der Entladung einer Mikrowellenresonator-Kapazität 43 vorzuverlegen, kann der freie Abstand zwischen deren Funkenstrecken-Elektroden 14-15 verringert oder der Druck des fluiden Dielektrikums im Innern dieses Resonators abgesenkt werden - und umgekehrt. Zum Realisieren der erstgenannten Möglichkeit kann gemäß Fig. 2 vorgesehen sein, die spitze Elektrode 15 in Form des durch den Resonator-Boden 41 hindurch geschraubten Bolzens 27 motorisch zu verdrehen. Dafür ist er mit einem miniaturisierten Getriebemotor 28 ausgestattet, der nach Maßgabe des Verzugszeit-Messergebnisses vom zugeordneten Zeitmesskanal über die Steuerschaltung 25 angesteuert wird, um über die Veränderung der Länge der Funkenstrecke 13 deren Ansprechzeitpunkt - in Bezug auf die nicht verzögerte und deshalb als Referenz nicht mit einer solchen Stelleinrichtung ausgestattete Funkenstrecke 13 (oben links in Fig. 2) - zu verändern. Wenn die Elektrode 15 nicht geschraubt sondern auf Gleitreibung gehalten ist, kann sie über den oben erwähnten Linearmotor (mit Fluid- oder Piezostellglied) in Bezug auf die Gegenelektrode 14 verschoben werden.

In Fig. 2 ist unten rechts berücksichtigt, dass statt dessen oder zusätzlich aus der Steuerschaltung 25 alternativ ein Pumpenmotor 29 oder ein Entspannungsventil 30 betrieben werden kann, um den Druck des fluiden Dielektrikums in der Umgebung der Funkenstrecke 13 und somit zwischen Innenelektrode 48 und Außenelektrode 45 des kapazitiven Resonators 43 aus einem Vorratsbehälter 31 zu erhöhen oder über das Ventil 30 zu verringern.

Um mit hinreichender Mikrowellenenergie auf ein Ziel mit einer zu störenden oder zu zerstörenden elektronischen Einrichtung einwirken zu können, werden also erfindungsgemäß die Strahlen 7 von wenigstens zwei Antennen-Arrays 10 auf einen Wirkbereich 8 in der Umgebung jenes Zieles fokussiert, vorzugsweise von einem mit diesen Arrays 10 ausgestatteten Fahrzeug 9 oder dergleichen Plattform aus; wobei für eine wirkungsvolle Überlagerung der abgestrahlten Mikrowellenenergie 7 in Abstrahlrichtung jeweils eines der Arrays 10 sowie auch der Arrays 10-10 untereinander das Einsetzen des Lichtbogens zum Entladen der Kapazität 43 des Resonators über dessen Funkenstrecke 13 beobachtet und quasi-kontinuierlich optoelektronisch erfasst wird. Dabei kann der Überlagerungsbereich 8 verschwenkt und wie in Fig. 1 berücksichtigt insbesondere auf einen Seitenstreifen neben dem Fahrweg gerichtet werden, wenn eine definierte Verzögerung in der aufeinanderfolgenden Anregung der beiden Arrays 10-10 eingesellt wird. Für die Zündpunkteinstellung wird der Elektrodenabstand der Funkenstrecke 13 bzw. der Fluiddruck des Dielektrikums in der Umgebung der Funkenstrecke 13 wie erwähnt etwa mittels motorischer Stellglieder so verändert, dass alle Funkenstrecken 13 eines Array 10 praktisch gleichzeitig oder aber (zur Strahlschwenkung) definiert gegeneinander versetzt zünden, womit deren zur Abstrahlung der Mikrowellenenergie 7 führenden Entladestromimpulse phasengesteuert einsetzen.

## Patentansprüche

1. Antennen-Array (10) mit mehreren, parallel geschalteten Mikrowellengeneratoren (11), wobei jeder Mikrowellengenerator (11) mit einer Kurzschluss-Funkenstrecke (13) zwischen den Elektroden (48, 45) seines an eine Antenne (18) angeschlossenen kapazitiven Mikrowellen-Resonators (33) versehen ist, und wobei die Funkenstrecken (13) auf gleiches zeitliches Ansprechverhalten einstellbar sind,
**dadurch gekennzeichnet,**
**dass** das Antennen-Array ferner mehrere optoelektronische Detektoren (21) und einen mehrkanaligen Zeitzähler (24) umfasst,
- **dass** zum Feststellen des Zeitpunkts des Ansprechens der jeweiligen Funkenstrecke (13) jeweils ein zugehöriger optoelektronischer Detektor (21) angeordnet ist,
- **dass** die Detektoren (21) auf den mehrkanaligen Zeitzähler (24) geschaltet sind, und
- **dass** die Ansteuerung des Zeitzählers (24) in jedem Kanal bis auf einen Kanal über eine Verzögerung (26) vor oder hinter dem entsprechenden Detektor (21) erfolgt.

2. Antennen-Array nach Anspruch 1,
**dadurch gekennzeichnet,**
**dass** die Detektoren (21) über Lichtleiter (22) an die nähere Umgebung der Funkenstrecken (13) im Resonator (43) angeschlossen sind.

3. Antennen-Array nach Anspruch 2,
**dadurch gekennzeichnet,**
**dass** die Verzögerung (26) über die Länge des Lichtleiters (22) vom Detektor (21) zur Funkenstrecke (13) realisiert ist.

4. Antennen-Array nach Anspruch 2,
**dadurch gekennzeichnet,**
**dass** die Verzögerung (26) schaltungstechnisch zwischen dem Detektor (21) und dem Zeitzähler (24) realisiert ist.

5. Antennen-Array nach einem der vorangehenden Ansprüche,
**dadurch gekennzeichnet,**
**dass** eine Steuerschaltung (25) zur Beeinflussung des Ansprechverhaltens der einzelnen Funkenstrecken (13) in Abhängigkeit von dem Ergebnis des Zeitzählers (24) für die den jeweiligen Funkenstrecken (13) zugeordneten Kanäle vorgesehen ist.

6. Antennen-Array nach Anspruch 5,
**dadurch gekennzeichnet,**
**dass** die Funkenstrecken (13) mit einer mittels eines Stellelementes (28) einstellbaren Elektrode (15) ausgestattet sind.

7. Antennen-Array nach Anspruch 5,
**dadurch gekennzeichnet,**
**dass** ein Druck eines fluiden Dielektrikums in der Umgebung der Funkenstrecke (13) über einen Pumpenmotor (29) und/oder über ein Ventil (30) veränderbar ist.

8. Antennen-System mit zwei Antennen-Arrays (10) nach einem der vorangehenden Ansprüche,
**dadurch gekennzeichnet,**
**dass** die Antennen-Arrays (10) so angeordnet sind, dass deren Abstrahlungen in einem Wirkbereich (8) überlagert sind.

## Claims

1. Antenna array (10) with a plurality of microwave generators (11) connected in parallel, wherein each microwave generator (11) is provided with a short-circuit spark gap (13) between electrodes (48, 45) of its capacitive microwave resonator (33), which is terminated at an antenna (18), and wherein the spark gaps (13) can be set to have the same time response,
**characterized**
- **in that** the antenna array furthermore comprises a plurality of optoelectronic detectors (21) and a multi-channel timer (24),
- **in that** in each case an associated optoelectronic detector (21) is arranged in order to set the time at which the respective spark gap (13) responds,
- **in that** the detectors (21) are connected to the multi-channel timer (24), and
- **in that** the timer (24) in each channel, except for one channel, is driven with a delay (26) before or after the corresponding detector (21).

2. Antenna array according to Claim 1,
**characterized**
**in that** the detectors (21) are connected to the relatively close vicinity of the spark gaps (13) in the resonator (43) via optical fibres (22).

3. Antenna array according to Claim 2,
**characterized**
**in that** the delay (26) is provided by means of the length of the optical fibre (22) from the detector (21) to the spark gap (13).

4. Antenna array according to Claim 2,
**characterized**
**in that** the circuitry for the delay (26) is provided between the detector (21) and the timer (24).

5. Antenna array according to one of the preceding claims,
**characterized**
**in that** a control circuit (25) is provided in order to influence the response of the individual spark gaps (13) as a function of the result of the timer (24) for the channels associated with the respective spark gaps (13).

6. Antenna array according to Claim 5,
**characterized**
**in that** the spark gaps (13) are equipped with an electrode (15) which can be adjusted by means of a control element (28).

7. Antenna array according to Claim 5,
**characterized**
**in that** a pressure of a fluid dielectric in the vicinity of the spark gap (13) can be varied via a pump motor (29) and/or via a valve (30).

8. Antenna system with two antenna arrays (10) according to one of the preceding claims,
**characterized**
**in that** the antenna arrays (10) are arranged so that their emissions are superimposed in an effect area (8).

## Revendications

1. Réseau d'antennes (10) comportant plusieurs générateurs de micro-ondes connectés en parallèle (11), dans lequel chaque générateur de micro-ondes (11) est muni d'un éclateur à court-circuit (13) entre les électrodes (48, 45) de son résonateur à micro-ondes capacitif (33) raccordé à une antenne (18), et dans lequel les éclateurs (13) sont réglables sur la même réponse temporelle,
**caractérisé en ce que** le réseau d'antennes comprend en outre plusieurs détecteurs optoélectroniques (21) et un compteur de temps multicanal (24),
- **en ce que**, pour établir l'instant de la réponse de l'éclateur (13) respectif, il est prévu un détecteur optoélectronique (21) associé respectif,
- **en ce que** les détecteurs (21) sont connectés au compteur de temps multicanal (24), et
- **en ce que** la commande du compteur de temps (24) s'effectue dans chaque canal jusqu'à un certain canal par l'intermédiaire d'un retard (26) en amont ou en aval du détecteur (21) correspondant.

2. Réseau d'antennes selon la revendication 1,
**caractérisé en ce que** les détecteurs (21) sont raccordés dans le résonateur (43) par l'intermédiaire de guides d'ondes optiques (22) à l'environnement proche des éclateurs (13).

3. Réseau d'antennes selon la revendication 2,
**caractérisé en ce que** le retard (26) est créé par l'intermédiaire de la longueur du guide d'ondes optique (22) du détecteur (21) jusqu'à l'éclateur (13).

4. Réseau d'antennes selon la revendication 2,
**caractérisé en ce que** le retard (26) est créé par une technique à base de circuits entre le détecteur (21) et le compteur de temps (24).

5. Réseau d'antennes selon l'une quelconque des revendications précédentes,
**caractérisé en ce qu'**il est prévu un circuit de commande (25) destiné à agir sur le mode de réponse des éclateurs individuels (13) en fonction du résultat du compteur de temps (24) pour les canaux associés aux éclateurs (13) respectifs.

6. Réseau d'antennes selon la revendication 5,
**caractérisé en ce que** les éclateurs (13) sont dotés d'une électrode (15) réglable au moyen d'un élément de réglage (28).

7. Réseau d'antennes selon la revendication 5,
**caractérisé en ce qu'**une pression d'un diélectrique fluide dans l'environnement de l'éclateur (13) est modifiable par l'intermédiaire d'un moteur de pompe (29) et/ou par l'intermédiaire d'une soupape (30).

8. Système d'antennes comportant deux réseaux d'antennes (10) selon l'une quelconque des revendications précédentes,
**caractérisé en ce que** les réseaux d'antennes (10) sont disposés de manière à ce que leurs émissions se superposent dans une zone de travail (8).
